Europäisches Patentamt

(19) European Patent Office

Office européen des brevets

(11) Publication number: **0 234 524 B1**

# (12) EUROPEAN PATENT SPECIFICATION

(45) Date of publication of patent specification: **19.01.94**  (51) Int. Cl.⁵: **G01N  33/49**, G01N 33/574, //G01N24/08

(21) Application number: **87102435.2**

(22) Date of filing: **20.02.87**

(54) **Process for the detection of cancer using nuclear magnetic resonance.**

(30) Priority: **26.02.86 US 833840**

(43) Date of publication of application:
**02.09.87 Bulletin  87/36**

(45) Publication of the grant of the patent:
**19.01.94 Bulletin  94/03**

(84) Designated Contracting States:
**AT BE CH DE FR GB IT LI LU NL SE**

(56) References cited:
**US-A- 3 789 832**

**PATENT ABSTRACTS OF JAPAN, vol. 5, no. 118 ((P-73)(790), 30 July 1981&NUM;**

**CHEMICAL ABSTRACTS, vol. 81, no. 25, 23 December 1974, Columbus, OH (US); D.P. HOLLIS et al., p. 385, no. 167435e&NUM;**

**CHEMICAL ABSTRACTS, vol. 101, no. 11, 10 September 1984, Columbus, OH (US); P.T. BEALL et al., p. 431, no. 88226r&NUM;**

(73) Proprietor: **THE BETH ISRAEL HOSPITAL ASSOCIATION**
**330 Brookline Avenue**
**Boston, MA 02109(US)**

(72) Inventor: **Fossel, Eric T.**
**66 Priscilla Road**
**Chestnut Hill, MA 02167(US)**

(74) Representative: **Hoeger, Stellrecht & Partner et al**
**Uhlandstrasse 14 c**
**D-70182 Stuttgart (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

CHEMICAL ABSTRACTS, vol. 105, no. 11, 15 September 1986, Columbus, OH (US); L.C. WRIGHT et al., p. 455, no. 95403g&NUM;

ANALYTICAL CHEMISTRY, vol. 58, no. 14, December 1986, Washington, DC (US); D.L. RABENSTEIN et al., pp. 3178-3184&NUM;

COMPUTED TOMOGRAPHY, vol. 5, no. 2, 1961, US; D.G. TAYLOR et al., pp. 122-134&NUM;

DATABASE BIOSIS (BIOLOGICAL ABSTRACTS); O.P. REBOKATOV et al., no. 76019795&NUM;

DATABASE BIOSIS (BIOLOGICAL ABSTRACTS); K.E. EKSTRAND et al., no. 65047264&NUM;

PRACTICAL NMR SPECTROSCOPY, 1980, Heyden & Son Ltd., London (GB); M.L. MARTIN et al., pp. 38-43&NUM;

MAGNETIC RESONANCE IN MEDICINE, vol. 2, no. 4, August 1985, New York, NY (US); K. GERSONDE et al., pp. 390-401&NUM;

## Description

The present invention relates to a diagnostic method and apparatus for the detection of cancer in a living patient.

Attempts utilize the technique of nuclear magnetic resonance (NMR) to aid in arriving at a clinical diagnosis of cancer are well known in the prior art.

Damadian was the first to propose any medical use for nuclear magnetic resonance (NMR) and that was for the detection of malignancy. See R. Damadian, "Tumor Detection by Nuclear Magnetic Resonance," Science 171:1151-1153 (1971). U.S. Patent 3,789,832 issued to Damadian covering an apparatus and method for application of nuclear magnetic resonance to surgically removed specimens to measure $T_1$ and $T_2$ for proton relaxation times, which values compared against values for healthy tissue were taken as an indication of cancer. U.S. Patent Nos. 4,411,270 and 4,354,499 issued to Damadian cover apparatus and method for cancer detection with NMR imaging and scanning of whole-body specimens.

A number of other investigators also reported that nuclear magnetic resonance relaxation times ($T_1$) for water protons in organs of tumor-bearing animals have higher values than the corresponding $T_1$ for water structure in organs of healthy animals. See Frey et al, J. Natl. Cancer Inst. 49, 903 (1972); Inch et al, J. Natl. Cancer Inst. 52, 353 (1974); Iijima et al, Physiol. Chem. and Physics 5, 431 (1973); and Hazlewood et al, J. Natl. Cancer Inst. 52, 1849 (1974).

Today, despite uncertainty regarding mechanistic details, it is well known that biophysical changes which occur in malignant cells often result in alterations of the proton NMR signal. See D.G. Taylor et al, "A Review of the Magnetic Resonance Response of Biological Tissue and Its Applicability to the Diagnosis of Cancer by NMR Radiology," Computed Tomography, 5:122-133 (1981). Such changes form the physical basis for detection of tumors by proton NMR imaging. See R. Zimmerman et al, "Cerebral NMR: Diagnostic Evaluation of Brain Tumors by Partial Saturation Technique with Resistive NMR," Neuroradiology 27:9-15 (1985) and K. Ohtomo, "Hepatic Tumors: Differentiation by Transverse Relaxation Time ($T_2$) of Magnetic Resonance Imaging," Radiology 155:421-423 (1985). However, NMR imaging is not likely to be widely applied as a screening test for malignancy because of accessibility and economic factors.

Proton NMR studies on excised tumors, as well as on plasma and serum, from experimental animals and patients have often shown differences in the relaxation parameters $T_1$, $T_2$ and $T_2^*$ as a function of malignancy. Such findings have been reported by the following:

L. McLachlan, "Cancer-induced Decreases in Human Plasma Proton NMR Relaxation Rates," Phys. Med. Biol. 25:309-315 (1980);

F. Smith et al, "Nuclear Magnetic Resonance Imaging of the Pancreas," Radiology 142:677-680 (1982);

P. Beall et al, "The Systemic Effect of Elevated Tissue and Serum Relaxation Times for Water in Animals and Humans with Cancers," NMR Basic Principles and Progress, P. Diehl et al, Eds., 19:39-57 (1981);

R. Floyd, "Time Course of Tissue Water Proton Spin-lattice Relaxation in Mice Developing Ascites Tumor," Cancer Res. 34:89-91 (1974);

C. Hazelwood et al, "Relationship Between Hydration and Proton Nuclear Magnetic Resonance Relaxation Times in Tissues of Tumor Bearing and Nontumor Bearing Mice: Implications for Cancer Detection," J. Natl. Cancer Inst. 52:1849-1853 (1974); and

R. Klimek et al, "A Discussion of Nuclear Magnetic Resonance (NMR) Relaxation Time of Tumors in Terms of Their Interpretation as Self-organizing Dissipative Structures, and of Their Study by NMR Zeugmatographic Imaging," Ginekol Pol. 52:493-502 (1981).

However, due to extensive overlap of groups and small differences between the means of groups, these methodologies are not clinically useful.

While most of the prior art mentioned above describes applications of NMR to analysis of tissue, it is also known to subject body fluids to such analysis. This is described, for example, by Beall et al., supra. Pat.Abs Japan,30/07/81 5(118), P-73)(790) 56-58649 proposes the measurement of the concentration of lactic acid in a serum sample by way of proton nuclear magnetic resonance. Pract.NMR Spect. Martin et al,1980, Heyden & Son pp 38-43 teaches that the full width at half height of a resonance line results from relaxation processes. Neither document suggests that the detection of cancer could be made from the full width of a resonance line at a predetermined height of a lipid component.

The foregoing prior art studies and methods, as well as all other prior art NMR methods for the detection of malignancy, rely on the observation of the composite NMR signal arising from all protons in the tissue or blood derived samples. This composite signal is dominated by the protons of water, obscuring the NMR signal from other proton-containing constituents of the sample. Indeed, the prior art believed that the apparent correlation between malignancy and observed changes in NMR parameters was due to "changes in water structure," quoting Frey et al., supra.

In other applications of proton NMR spectroscopy, it was known to suppress the signal from the solvent (such as water) in a sample.

At present, a reliable and statistically unequivocal NMR method of diagnosing the presence of cancer in a living patient has not been developed.

Accordingly, one object of the invention is to provide a method of and apparatus for diagnosing the presence of cancer in a living patient.

Yet another object is to provide such a method which can be carried out on a sample of a bodily fluid drawn from a patient.

Still another object of the present invention is to apply NMR spectroscopy in a manner which achieves the foregoing objectives.

These and other objects and features of the present invention will become apparent to those skilled in the art from a reading of the description of the invention which follows.

The invention proceeds from the realization that the components of the NMR spectrum which have significant predictive value may be masked by other materials in the sample. By eliminating the masking, as by eliminating the water signal, the previously masked spectrum of these components is revealed.

In accordance with the invention, a sample of a patient's bodily fluid is subjected to nuclear magnetic resonance spectroscopy to generate a nuclear magnetic resonance spectrum. A resonance line generated by a non-water component of the sample is selected, and the full width of this resonance line, e.g., at half its height, is measured. The full width so measured has proved to be a statistically reliable measure of the presence or absense of cancer in the patient.

In a preferred embodiment, there is provided a means for storing a predetermined value or range of values which are associated with individuals in which cancer is absent. There is also provided a means for comparing the measured linewidth with the value or range of values so stored.

In preferred embodiments, the bodily fluid is blood, spinal fluid, or bone marrow plasma; blood is especially advantageous. The component of interest is lipidic, and is preferably from the methyl and methylene groups of the lipoprotein lipids; and the water signal is suppressed to make the resonance lines of the components of interest more pronounced.

In the drawings:

Figure 1 is a typical NMR spectrum for the non-water components of a plasma sample from a healthy control centered on 360 MHz, obtained in accordance with the present invention;

Figure 2 is an NMR spectrum for the same plasma sample from which the spectrum of Figure 1 was obtained, using the same equipment and pulse frequency, except without water suppression;

Figure 3 is an expanded view of the methyl and methylene region of Figure 1;

Figure 4 is similar to Figure 3 but for a patient with an untreated malignancy; and

Figure 5 schematically illustrates apparatus in accordance with the invention.

The water suppressed proton NMR spectrum obtained on human blood plasma is dominated by the resonances of the plasma lipoprotein lipids. Without water suppression, these non-water resonances are virtually overwhelmed by the water. Signal averaging allows observation of resonances of some moieties associated with non-water bodily fluid components, at high magnetic fields, even in the presence of the water resonance. However, the capability of modern NMR spectrometers to suppress nearly completely the water proton resonance facilitates practice of the present invention. The water suppressed proton NMR spectrum of plasma is essentially that of plasma lipoproteins and a few low molecular weight molecules. The protons of the proteins of plasma are obscured because they comprise a broad smear of unresolved resonances. The sharper resonances of the more mobile lipoprotein protons are superimposed on this broad background.

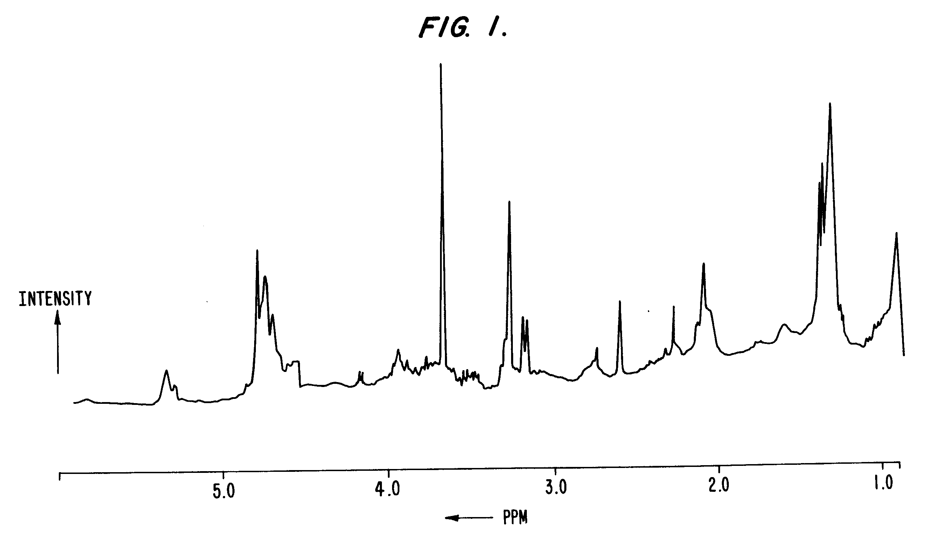

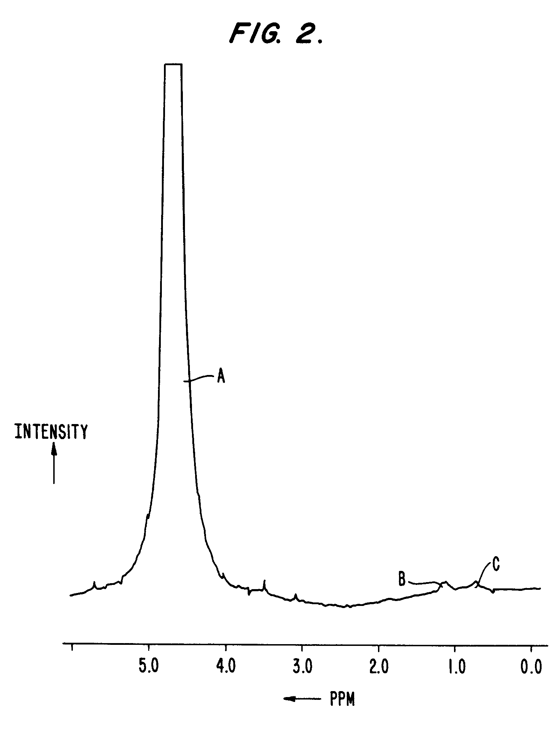

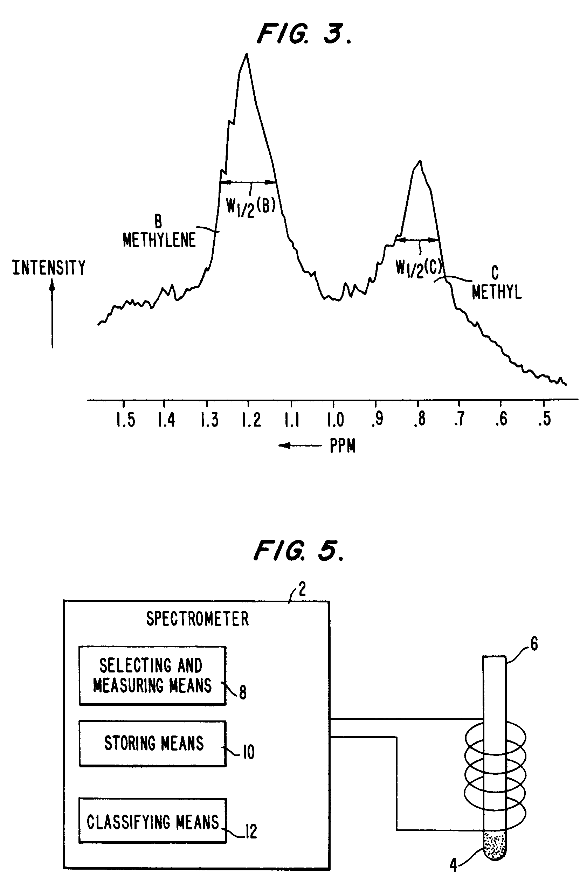

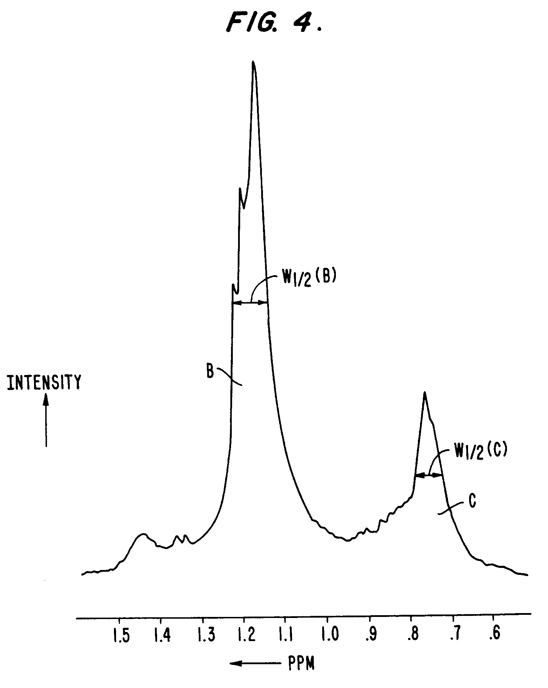

Figure 1 shows a water suppressed proton spectrum of a healthy control, and Figure 2 shows a proton spectrum of the same sample without water suppression. The truncated resonance line of water is denoted A in Figure 2. The resonance lines between 0 and 2 ppm (parts per million of resonance frequency) arise from the methyl and methylene groups of the lipoprotein lipids. An expanded view of this region of the proton spectrum is shown in Figure 3 for a normal control and in Figure 4 for a patient with untreated malignancy. Accordingly, in its preferred embodiments the present invention uses one of a number of conventional water suppression techniques, i.e., techniques for suppression of the water proton NMR signal. Numerous techniques have been devised to suppress the water proton NMR signal in other contexts. These may be broadly divided into two categories: (1) those that aim not to excite the water proton signal, e.g., rapid scan correlation spectroscopy and the selective excitation technique, and (2) those that arrange for the water proton magnetization to be extremely small at the time the observe radiofrequency (rf) pulse is applied, e.g., the inversion recovery technique and saturation. These and other solvent suppression

4

techniques are described by P.J. Hore in "Solvent Suppression in Fourier Transform Nuclear Magnetic Resonance," Journal of Magnetic Resonance 55,283-300 (1983) and the references footnoted therein. The preference for use of a water suppression technique in the present invention is dictated by limitations of the apparatus in distinguishing between the signal of the solvent protons and those of the moiety or species of interest. Accordingly, a sufficiently sensitive apparatus would eliminate the need for water suppression.

In a preferred embodiment of the present invention the linewidth at half-height of the resonances of moieties, e.g., methyl and methylene groups, associated with the lipids of plasma lipoproteins are treated as the variable of interest. Full width at half-height $W_{\frac{1}{2}}$ (linewidth) of an NMR resonance line is inversely proportional to the apparent spin-spin relaxation time

$$(T_2{}^*), \text{ i.e. } W_{\frac{1}{2}} = \frac{1}{\pi T_2{}^*}.$$

The process of the present invention operates on any lipid-containing bodily fluid, e.g., blood, spinal fluid or bone marrow plasma. Whole blood, serum or plasma may be used. While the test may be performed on any such lipid-containing body fluid, work to date has focused on whole blood, blood serum and blood plasma. In blood the lipids, inclusive of cholesterol, triglycerides and phospholipids, are present in the form of lipoproteins. The test for cancer will typically be performed in vitro, preferably on serum or plasma.

The selected fluid of a suspect patient or other person to be screened for cancer is exposed to a magnetic field and radiofrequency energy to generate a nuclear magnetic resonance signal which is then processed to obtain a value for the selected parameter, e.g., $W_{\frac{1}{2}}$, for lipid methyl and/or methylene protons. A relatively broad range of proton frequencies may be employed, e.g., 60 MHz and higher, preferably 200-400 MHz.

The detected value for the selected parameter is then compared with the corresponding parameter for the healthy controls. In a preferred embodiment, values for methyl and methylene are averaged and an average value of 33 Hz or less (at a proton frequency of 360 MHz (8.45T) or 400 MHz (9.40T)) is taken as an indication of malignancy.

Any conventional modern NMR spectrometer may be used in the practice of the present invention. In the preferred embodiments, an NMR spectrometer with a magnet at constant field strength is used and the NMR signal is Fourier transformed, with the full linewidth at half-height for proton resonances of methyl and methylene groups being the NMR parameter of interest.

The present invention provides statistically and clinically significant differences in plasma lipoprotein lipid linewidth measurements as between patients with untreated malignancies, patients undergoing treatment for malignancies, patients with benign tumors, pregnant women and control groups.

The example which follows serves to further illustrate a preferred embodiment of the present invention.

Blood samples were obtained from 214 individuals. Six patients were deleted because sufficient records were unobtainable; Data are reported for the remaining 208. In addition to plasma NMR measurements, HDL cholesterol levels were measured for most of the samples. Normal control samples were obtained from apparently healthy hospital personnel. Patients were selected from both the inpatient and outpatient populations. Patients with untreated malignancies, benign tumors, and surgically correctable conditions were selected blindly on several occasions by retrieving the blood samples of all preoperative patients for a given day. Patients with non-malignant illnesses were also studied in order to determine effects of certain disorders on the NMR measurements. Patients were particularly sought who had conditions with high cell turnover (ulcerative colitis, psoriasis, pregnancy), metabolic derangements (renal failure, hepatic failure, hyperthryroidism, diabetes) or cachexia and overwhelming illness. The patients were classified into six groups as shown in Table 1 on the basis of a detailed review of each patient's chart with respect to clinical and pathological diagnosis, extent of disease as evidenced by clinical, radiological, and laboratory measurements, and therapeutic interventions.

Blood was collected into Vacutainer tubes containing EDTA. In some cases citrated samples were also obtained for comparison with EDTA samples. Heparin or any other anticoagulent could likewise have been used to stop the blood from coagulating to a non-liquid form. Each sample was then centrifuged to separate out the red cells and the supernatant plasma was removed and used for NMR analysis.

Proton NMR spectra were obtained at radiofrequency pulses at either 360 MHz or 400 MHz using Bruker AM Pulsed Fourier transform spectrometers and a 5mM OD proton probe. All samples were prepared in 5 mm OD tubes with, in most cases, a minimum of 0.4 ml plasma. Water suppression was accomplished by presaturation, applying discrete radio-frequency power at the position of the water resonance for six seconds prior to the 90° observation pulse. Sixteen free-induction decays were signal averaged and the resulting free induction decay was Fourier transformed resulting in a spectrum such as that shown in Figure 1. An expanded version of the aliphatic region (0-2 ppm) was plotted and the full width at half-height $W_{\frac{1}{2}}$ of the methyl (line C) and methylene (line B) resonances was measured. The average of these two values $W_{\frac{1}{2}}(B)$ and $W_{\frac{1}{2}}(C)$, in Hertz, was used as the indicative parameter. No perceptable difference was noted between 8.45 T (360 MHz) and 9.40 T (400 MHz). In order to analyze these results in comparison with previous methods, $T_1$ values of samples with sufficient plasma volume (0.8 ml) were determined in an IBM mini-spec model PC-20 NMR spectrometer using the standard inversion recovery pulse sequence. The composite proton signal is observed at 20 MHz. The data thus obtained for each of the six groups of patients is summarized in Table 1 on the next page:

6

TABLE 1

| Designation | I Control | II Malignant Tumor | III Non-tumor Disease | IV - Benign Tumor | | | V Preg-nancy | VI Malignant Tumor Treated |
|---|---|---|---|---|---|---|---|---|
| | | | | Breast/ Ovary/ Uterus | Endo-crine | Prostate | | |
| Number | 40 | 64[a] | 46 | 8 | 5 | 10 | 12 | 29[b] |
| Male | 15 | 29 | 28 | 0 | 2 | 10 | 0 | 14 |
| Female | 25 | 30 | 18 | 8 | 3 | 0 | 12 | 14 |
| Age Range | 22-58 | 24-90 | 20-91 | 32-46 | 23-85 | 58-80 | 20-37 | 16-86 |
| Linewidth | 40.1±1.4 | 29.0±2.7 | 36.9±2.2 | 38.9±1.6 | 33.4±3.5 | 32.2±3.2 | 31.0±3.4 | 33.2±3.9[c] |
| $T_1$ | 1.91±0.18 | 1.98±0.21 | 1.94±0.14 | | | | | |
| HDL Cholesterol | 50±14 | 38±18 | 43±28 | | | | | |

a One patient was tested before treatment and with progressive disease after treatment.

b Four patients were also tested before treated.

c See text for further evaluation.

NOTE: There were a total of 214 patients ranging in age from 16 to 91 years.

In experiments, linewidth measurements would detect changes as small as one Hertz. The reproductibility of the measurement expressed as differences in multiple determinations on the same sample was also one Hertz.

The tumor type or disease type, together with the linewidth range, for each type are given in tables 2-5 below.

TABLE 2

Tumor distribution and linewidth range for patients in Group II.

| Primary Tumor | Number | Linewidth Range |
|---|---|---|
| Breast | 12 | 28.0-32.5 |
| Gastrointestinal (colon, gastric, pancreatic ca) | 8 | 23.0-33.5 |
| Lymphomas (diffuse histiocytic, nodular poorly differentiated) | 6 | 27.5-32.5 |
| Leukemias (CLL, AMMOL, AML, CML) | 9 | 25.5-31.0 |
| Genitourinary (prostate, bladder, testicular, renal cell, ovarian, endometrial, teratocarcinoma) | 12 | 22.0-33.0 |
| Lung (adenocarcinoma, squamous cell ca, oat cell) | 6 | 24.5-31.5 |
| Central Nervous System (neural sarcoma, meningioma, glioblastoma) | 5 | 27.5-33.0 |
| Head & Neck | 2 | 31.0,31.5 |
| Miscellaneous (melanoma, thymoma, mesothelioma, Ewing sarcoma) | 4 | 23.0-31.5 |

TABLE 3

Tumor burden and linewidth range for patients in Group II.

| Tumor Burden | Number | Linewidth Range |
|---|---|---|
| Localized | 21 | 23.0-33.0 |
| Locally invasive | 14 | 22.0-31.5 |

| | | |
|---|---|---|
| Metastatic | 20 | 24.0-33.5 |
| Systemic (leukemias) | 9 | 25.5-31.0 |

TABLE 4

Disease distribution and linewidth range for patients in Group III

| Disease | Number | Linewidth Range |
|---|---|---|
| Cardiovascular | 6 | 35.5-38.5 |
| Pulmonary | 2 | 39.0,41.5 |
| Orthopedic | 4 | 36.5-41.5 |
| Gastrointestinal | 7 | 34.5-40.0 |
| Sepsis | 4 | 34.5-37.0 |
| Endocrine | 3 | 35.0-37.5 |
| Renal | 3 | 34.5-37.0 |
| CNS | 3 | 34.0-39.5 |
| Hematological | 4 | 36.0-40.5 |
| Genitourinary | 5 | 34.0-43.0 |
| Miscellaneous | 5 | 33.0-40.0 |

TABLE 5

Tumor distribution and linewidth range for patients in Group VI.

| Primary Tumor | Number | Linewidth Range |
|---|---|---|
| Breast | 7 | 28.5-38.5 |
| Gastrointestinal | 1 | 30 |
| Lymphomas | 1 | 29.2 |
| Leukemias | 9 | 25-39 |
| Genitourinary | 4 | 28-41 |
| Lung | 2 | 31, 33 |
| CNS | 1 | 34.5 |
| Head & Neck | 1 | 34.5 |
| Endocrine | 1 | 33.5 |
| Miscellaneous | 1 | 39.5 |

The experimental data (Tables 1-5) shows a significant difference between Group I and Group II (p<0.0001). This data demonstrates that lipoprotein lipid linewidth discriminates between patients with uncontrolled proliferative disease and normal controls. This result is in contrast to various measurements which have been reported in the prior art in connection with attempts to differentiate patients with malignancies. Two of such prior art methods are plasma high density lipoprotein (HDL) cholesterol levels and the NMR spin-lattice relaxation parameter $T_1$ for the total proton spectrum of plasma. Table 1 shows that there was a small increase in the mean $T_1$ for Group II, but there was significant overlap between this group and the control group. $T_1$ values for 69% of the patients were within 1 standard deviation of the normal mean value, and 96% were within 2 standard deviations. Consequently, measurement of total plasma proton $T_1$ was not found to be diagnostic of malignancy. Similarly, although mean HDL cholesterol decreased in Group II, the overlap with the control group was sufficiently large so as to be nondiagnostic.

There was a small decrease in mean lipoprotein lipid linewidth for patients with benign tumors (Group IV) and patients with diseases other than malignancies (Group III), as compared to Group I (0.05>p>0.02). Groups III and IV are both clearly different from Group II (p<0.0001). There was, however, marked overlap between pregnant women (Group V) and Group II (p>0.05). Group VI was clinically the most heterogeneous and also had the largest range of linewidth values.

Linewidth measurements were found to be diagnostic of malignant disease but not of tumor type or tumor burden (Table 2).

Patients in Group IV all had benign tumors confirmed by biopsy reports. The mean linewidth of samples from these patients, which were obtained shortly before biopsy was lower than the mean value for normal healthy adults. Comparison of patients in Groups II and IV, paired for benign and malignant tumors, indicates that linewidth measurements are discriminative between the two groups (Table 3) (p<0.0001). One elderly patient with benign prostatic hypertrophy was the only exception, which raises the possibility of a small, undetected focus of malignancy in this patient.

Group III patients were selected for non-tumor diseases and included a wide spectrum of disorders (Table 4). This population ranged from moderately to severely ill, with emphasis on the severely ill. This group was specifically designed to include elderly patients and patients with poor nutritional status, acute infection, renal failure, endocrine abnormalities, or proliferative, non-tumor disorders (e.g., polycythemia, ulcerative colitis, psoriasis). The objective in selecting these patients was to determine if severe illness per se, in the absence of clinically or pathologically evident malignancy, would result in linewidth measurements which were the same as those of the patients with malignancies. The results indicate that severe illness or proliferative disease alone does not produce change in lipoprotein lipid linewidth comparable to that of malignancy. However, it was observed that the mean linewidth value for this group was lower than for the control group (0.05>p>0.02). Eighteen of the 46 patients, including some patients with acute myocardial infarction, ulcerative colitis, polycythemia vera, and myelofibrosis, had values within two standard deviations of the normal mean, with the remainder falling slightly below. However, only one patient in this group (linewidth = 33 Hz) overlapped with the malignant patients in Group II. This was a male, age 28, with an umbilical hernia.

A small cohort of pregnant women was also studied (Group V). The rationale for selecting these patients was that if the change observed in malignancies was reflective of rapid, proliferative growth, then pregnant women should have values intermediate between benign and malignant tumor patients. The results indicated that this hypothesis is correct. Samples were obtained from five women at term, from two at the beginning of the third trimester, from three in the second trimester, and from two in the first trimester. As with the tumor patients, a single sample did not reflect fetal size but did indicate proliferative activity.

Group VI constitutes a heterogeneous assortment of tumor patients undergoing or having recently completed treatment ( <6 months), for whom it was too early to determine their response to therapy. This group also had the greatest range of linewidth measurements, as would be expected (Table 5), although the results suggest that changes in lipoprotein lipid linewidth in an individual tumor patient during therapy reflect the effect of treatment in the patient. Thus, a series of measurements can reflect the response of the patient to therapy.

Referring now to Figure 5, there is illustrated a nuclear magnetic resonance (NMR) spectrometer 2 which in the preferred embodiment is capable of performing proton NMR spectroscopy and which is preferably but not necessarily of the type that suppresses the NMR signal of water. The spectrometer 2 is adapted for examination of a sample 4, which in this example is human blood plasma contained within a test tube 6.

In accordance with the invention, the spectrometer 2 contains means 8 for selecting at least one and preferably a plurality such as two NMR resonance lines in the NMR spectrum of the sample 4 and measuring the line-width of the line or lines so selected. Preferably, the linewidth is measured at half the height of the line, but this is not necessary and linewidth can be measured at any Predetermined fraction of the height of the line in question. Measurement at half of line height is preferred because this is a standard measurement carried out in the field of NMR spectroscopy.

The spectrometer 2 is of conventional construction and includes in addition to all its other structure a means 10 for storing a value or range of values. In the preferred embodiment, a linewidth which is either measured directly or derived from a plurality of such direct measurements is compared with a value or range of values which represents the value or range of values to be expected from normal patients, i.e. patients who are free of cancer. In accordance with the invention, the spectrometer 2 also includes means

EP 0 234 524 B1

12 for classifying the measured or derived linewidths as normal (i.e. cancer-free) or abnormal (i.e. cancerous) based upon the stored information. This may be done by comparison, subtraction, or any other appropriate mathematical operation.

In the preferred embodiment, the selecting and measuring means 8 is preadjusted to measure the linewidths of the methyl and methylene groups of the lipoprotein lipids. This may be done by suppressing the signal of water from the NMR spectrum of the sample 4, or may alternatively be done directly where the spectrometer 2 is sensitive enough to do so.

In the preferred embodiment, the linewidths of the methyl and methylene groups are averaged to produce a composite linewidth which is the mathematical mean of the two. This composite linewidth is preferably then compared with 33 Hz, the value which is preferably stored in the means 10. The actual comparison is carried out by the classifying means 12. Where the comparison indicates that the composite linewidth is less than 33 Hz, this indicates an abnormal (i.e. cancerous) sample 4.

**Claims**

1. Method for diagnosing the presence of cancer in a living patient, comprising the following steps:
   (a) Subjecting a bodily fluid sample from the patient to nuclear magnetic resonance spectroscopy to generate a NMR spectrum from which undesirable masking water signals have been suppressed;
   (b) Selecting a NMR resonance line in said spectrum from a lipid component;
   (c) Measuring the full width of said resonance line at a predetermined fraction of its height; and
   d) Classifying the full width so measured into the category of normal full widths or into the category of abnormal full widths.

2. Method according to claim 1, wherein the bodily fluid sample is a blood component sample.

3. Method according to claim 1 or 2, wherein said subjecting step comprises taking a blood sample obtained from the patient, removing red cells therefrom, and subjecting the plasma in the blood sample to nuclear magnetic resonance spectroscopy.

4. Method according to anyone of the claims 1 to 3, wherein the nuclear magnetic resonance spectroscopy is of the proton type.

5. Method according to claim 4, wherein the proton resonance is above 60 MHz.

6. Method according to claim 5, wherein the proton resonance is within the range of 200 - 400 MHz.

7. Method according to anyone of the claims 1 to 6, wherein a plurality of resonance lines is selected, the full width of which is measured at a predetermined height and wherein from all full widths measured in this way a composite line width is derived and classified into the category of normal composite line widths or into the category of abnormal composite line widths.

8. Method according to claim 7, wherein said deriving step comprises the step of computing the mathematical mean.

9. Method according to claim 7 or 8, wherein said plurality is two.

10. Method for detecting cancer comprising:
    (a) Establishing a value for at least one NMR parameter for nucleii of at least one moiety associated with a lipid constituent of a lipid-containing bodily fluid sample of cancer-free subjects;
    (b) Subjecting-the same type bodily fluid of a subject to be diagnosed for cancer to a magnetic field and a radio-frequency energy to generate a nuclear magnetic resonance spectrum;
    (c) Processing the nuclear magnetic resonance spectrum to obtain a value for said parameter of said moiety nucleii;
    (d) Comparing the value established for said parameter in (a) with the value obtained in (c).

11. Method according to anyone of claims 1 to 10, wherein the sample is blood, blood plasma, blood serum, spinal fluid or bone marrow plasma.

11

**12.** Method according to anyone of claims 1 to 11, wherein the full width is measured at half-height of the resonance line.

**13.** Method according to anyone of claims 1 to 12, wherein said resonance line(s) correspond to a methyl and/or methylene groups.

**14.** Method according to claim 13, wherein the methyl and/or methylene groups are associated with lipoprotein.

**15.** Method according to claim 10, wherein said lipid-containing bodily fluid has been removed from the subject to be diagnosed prior to steps (b) and (c) which are conducted in vitro.

**16.** Method according to anyone of claims 10 and 15, wherein said NMR parameter is an average value derived from the resonance lines of methyl and methylene protons.

**17.** Method according to anyone of claims 10, 15 and 16, wherein said parameter is the apparent spin-spin relaxation time $T_2{}^*$.

**18.** NMR spectrometer designed for performing a method according to anyone of the preceeding claims, comprising:
   (a) Means for generating a NMR spectrum from a sample;
   (b) Means for suppressing undesired masking water signals;
   (c) Means for selecting a resonance line from said spectrum from a lipid component and measuring the width of said line at a predetermined fraction of its height;
   (d) Means for storing a range of width values of resonance lines; and
   (e) Means for determining whether the width measured in this way is within said range of values.

**19.** NMR spectrometer of claim 18, wherein said means for selecting a resonance line are capable of selecting a plurality of resonance lines and of measuring the widths of said lines at a predetermined fraction of its height;
   wherein the spectrometer comprises further means for deriving from all widths a composite line width; and
   means for classifying said composite line width into the category of normal composite line widths or into the category of abnormal composite line widths.

**Patentansprüche**

**1.** Verfahren zum Diagnostizieren des Vorhandenseins von Krebs in einem lebenden Patienten, welches die folgenden Schritte umfaßt:
   (a) Unterwerfen einer Probe einer Körperflüssigkeit des Patienten einer Kernresonanzspektroskopie, um ein NMR-Spektrum zu erzeugen, bei dem unerwünschte, maskierende Wassersignale unterdrückt wurden;
   (b) Auswählen einer NMR-Resonanzlinie einer Lipidkomponente in dem Spektrum;
   (c) Messen der Gesamtbreite der Resonanzlinie bei einem vorgegebenen Bruchteil ihrer Höhe; und
   (d) Klassifizieren der so gemessenen Gesamtbreite in die Kategorie der normalen Gesamtbreiten oder der abnormen Gesamtbreiten.

**2.** Verfahren nach Anspruch 1, worin die Körperflüssigkeitsprobe die Probe einer Blutkomponente ist.

**3.** Verfahren nach Anspruch 1 oder 2, worin der Schritt des Unterwerfens einer Kernresonanzspektroskopie das Entnehmen einer vom Patienten erhaltenen Blutprobe, das Entfernen der roten Blutkörperchen hieraus und das Unterwerfen des Plasmas der Blutprobe einer Kernresonanzspektroskopie umfaßt.

**4.** Verfahren nach einem der Ansprüche 1 bis 3, worin die Kernresonanzspektroskopie die Protonenresonanzspektroskopie ist.

**5.** Verfahren nach Anspruch 4, worin die Protonenresonanz oberhalb 60 MHz liegt.

EP 0 234 524 B1

**6.** Verfahren nach Anspruch 5, worin die Protonenresonanz im Bereich von 200 bis 400 MHz liegt.

**7.** Verfahren nach einem der Ansprüche 1 bis 6, worin mehrere Resonanzlinien ausgewählt werden, deren Gesamtbreite bei einer vorgegebenen Höhe gemessen wird, und worin aus allen gemessenen Gesamtbreiten eine zusammengesetzte Linienbreite abgeleitet wird und in die Kategorie der normalen zusammengesetzten Linienbreiten oder die Kategorie der abnormen zusammengesetzten Linienbreiten klassifiziert wird.

**8.** Verfahren nach Anspruch 7, worin der Schritt des Ableitens den Schritt der Berechnung des rechnerischen Mittelwertes umfaßt.

**9.** Verfahren nach Anspruch 7 oder 8, worin die mehreren Linien zwei sind.

**10.** Verfahren zum Erkennen von Krebs, umfassend:
(a) Ermitteln eines Wertes für mindestens einen NMR-Parameter für Kerne von mindestens einer Komponente eines Lipid-Bestandteils einer Lipide enthaltenden Körperflüssigkeit eines krebsfreien Subjekts;
(b) Unterwerfen desselben Typs einer Körperflüssigkeit eines auf Krebs zu diagnostizierenden Subjekts unter ein Magnetfeld und einer Energie im Radiofrequenzbereich zur Erzielung eines Kernresonanzspektrums;
(c) Verarbeiten des Kernresonanzspektrums, um einen Wert für den Parameter des Komponentenkerns zu erhalten;
(d) Vergleichen des im Schritt (a) ermittelten Wertes für den Parameter mit dem im Schritt (c) erhaltenen.

**11.** Verfahren nach einem der Ansprüche 1 bis 10, worin die Probe Blut, Blutplasma, Blutserum, Rückenmarkflüssigkeit oder Knochenmarkplasma ist.

**12.** Verfahren nach einem der Ansprüche 1 bis 11, worin die Gesamtbreite in halber Höhe der Resonanzlinie gemessen wird.

**13.** Verfahren nach einem der Ansprüche 1 bis 12, worin die Resonanzlinie(n) einer Methyl- und/oder Methylengruppen entsprechen.

**14.** Verfahren nach Anspruch 13, worin die Methyl- und/oder Methylengruppen mit Lipoprotein assoziiert sind.

**15.** Verfahren nach Anspruch 10, worin die Lipide enthaltende Körperflüssigkeit von einem zu diagnostizierenden Subjekt vor den Schritten (b) und (c), welche in vitro durchgeführt werden, entnommen wurden.

**16.** Verfahren nach einem der Ansprüche 10 und 15, worin der NMR-Parameter ein Mittelwert ist, der aus den Resonanzlinien der Methyl- und Methylenprotonen abgeleitet wurde.

**17.** Verfahren nach einem der Ansprüche 10, 15 und 16, worin der Parameter die scheinbare spin-spin Relaxationszeit $T_2^*$ ist.

**18.** NMR-Spektrometer, entworfen zur Durchführung eines Verfahrens gemäß einem der voranstehenden Ansprüche, umfassend:
(a) Mittel zum Erzeugen eines NMR-Spektrums von einer Probe;
(b) Mittel zum Unterdrücken unerwünschter, maskierender Wassersignale;
(c) Mittel zum Selektieren einer Resonanzlinie aus dem Spektrum von einer Lipidkomponente und zum Messen der Breite der Linie bei einem vorgegebenen Bruchteil der Höhe;
(d) Mittel zum Speichern eines Bereiches an Breitenwerten der Resonanzlinien; und
(e) Mittel zum Bestimmen, ob eine so gemessene Breite innerhalb des Wertebereiches liegt.

**19.** NMR-Spektrometer nach Anspruch 18, worin die Mittel zum Auswählen einer Resonanzlinie in der Lage sind, mehrere Resonanzlinien auszuwählen und die Breite dieser Linien bei einem vorgegebenen Bruchteil ihrer Höhen zu messen;

13

worin das Spektrometer ferner Mittel zum Ableiten einer zusammengesetzten Linienbreite aus allen Breiten umfaßt; und

Mittel zum Klassifizieren der zusammengesetzten Linienbreite in die Kategorie der normalen zusammengesetzten Linienbreiten und die Kategorie der abnormen zusammengesetzten Linienbreiten.

**Revendications**

1. Procédé de diagnostic de la présence d'un cancer chez un patient vivant, comprenant les étapes suivantes :

   (a) la soumission d'un échantillon de fluide corporel provenant du patient à une spectroscopie de résonance magnétique nucléaire pour générer un spectre RMN duquel des signaux masquants et indésirables d'eau ont été supprimés ;

   (b) la sélection d'une ligne de résonance RMN dans ledit spectre à partir d'un composant lipidique ;

   (c) la mesure de la largeur totale de ladite ligne de résonance à une fraction prédéterminée de sa hauteur ;

   (d) la classification de la largeur totale ainsi mesurée dans la catégorie des largeurs totales normales ou dans la catégorie des largeurs totales anormales.

2. Procédé selon la revendication 1, dans lequel l'échantillon de fluide corporel est un échantillon de composant sanguin.

3. Procédé selon la revendication 1 ou 2, dans lequel ladite étape de soumission comprend la prise d'un échantillon sanguin obtenu à partir du patient, l'élimination des globules rouges dudit échantillon et la soumission du plasma de l'échantillon sanguin à la spectroscopie de résonance magnétique nucléaire.

4. Procédé selon l'une quelconque des revendications 1 à 3, dans lequel la spectroscopie de résonance magnétique nucléaire est du type proton.

5. Procédé selon la revendication 4, dans lequel la résonance du proton est supérieure à 60 MHz.

6. Procédé selon la revendication 5, dans lequel la résonance du proton est comprise dans la gamme allant de 200 à 400 MHz.

7. Procédé selon l'une quelconque des revendications 1 à 6, dans lequel on sélectionne une pluralité de lignes de résonance, dont on mesure la largeur totale à une hauteur prédéterminée et dans lequel, à partir de toutes les largeurs totales mesurées de cette manière, on déduit une largeur de ligne composite et la classe dans la catégorie des largeurs de lignes composites normales ou dans la catégorie des largeurs de lignes composites anormales.

8. Procédé selon la revendication 7, dans lequel ladite étape de déduction comprend l'étape de calcul de la moyenne mathématique.

9. Procédé selon la revendication 7 ou 8, dans lequel ladite pluralité est égale à deux.

10. Procédé de détection du cancer comprenant :

    (a) l'établissement d'une valeur pour au moins un paramètre RMN pour des noyaux d'au moins un motif associé un constituant lipidique d'un échantillon de fluide corporel contenant des lipides obtenu de sujets non cancéreux ;

    (b) la soumission du fluide corporel de même type d'un sujet soumis à un diagnostic du cancer à un champ magnétique et à une énergie de radio-fréquence pour générer un spectre de résonance magnétique nucléaire ;

    (c) le traitement du spectre de resonance magnéticue nucléaire pour obtenir une valeur pour ledit paramètre desdits noyaux de motif, et

    (d) la comparaison de la valeur établie pour ledit paramètre selon (a) avec la valeur obtenue selon (c).

11. Procédé selon l'une quelconque des revendications 1 à 10, dans lequel l'échantillon est du sang, du plasma sanguin, du sérum sanguin, du fluide spinal ou du plasma de moelle osseuse.

14

**12.** Procédé selon l'une des revendications 1 à 11, dans lequel la largeur totale est mesurée à demi-hauteur de la ligne de résonance.

**13.** Procédé selon l'une quelconque des revendications 1 à 12, dans lequel la ou lesdites ligne(s) de résonance correspondent à un ou des groupes méthyle et/ou méthylène.

**14.** Procédé selon la revendication 13, dans lequel les groupes méthyle et/ou méthylène sont associés à une lipoprotéine.

**15.** Procédé selon la revendication 10, dans lequel le fluide corporel contenant les lipides a été prélevé depuis le sujet à diagnostiquer avant les étapes (b) et (c) qui sont mises en oeuvre in vitro.

**16.** Procédé selon l'une quelconque des revendications 10 et 15, dans lequel ledit paramètre RMN est une valeur moyenne déduite des lignes de résonance des protons méthyle et méthylène.

**17.** Procédé selon l'une quelconque des revendications 10, 15 et 16, dans lequel ledit paramètre est le temps apparent de relaxation spin-spin $T_2^*$.

**18.** Spectromètre RMN conçu pour mettre en oeuvre un procédé selon l'une quelconque des revendications précédentes, comprenant :
(a) des moyens pour générer un spectre RMN à partir d'un échantillon ;
(b) des moyens pour supprimer des signaux masquants et indésirables d'eau ;
(c) des moyens pour sélectionner une ligne de résonance à partir dudit spectre depuis un composant lipidique et mesurer la largeur de ladite ligne à une fraction prédéterminée de sa hauteur ;
(d) des moyens pour stocker une gamme de valeurs de largeur de ligne de résonance ; et
(e) des moyens pour déterminer si la largeur mesurée de cette manière tombe dans ladite gamme de valeurs.

**19.** Spectromètre RMN selon la revendication 18, dans lequel lesdits moyens pour sélectionner une ligne de résonance sont capables de sélectionner une pluralité de lignes de résonance et de mesurer les largeurs desdites lignes à une fraction prédéterminée de leur hauteur ;
ledit spectromètre comprenant en outre des moyens pour déduire, depuis toutes les largeurs, une largeur de ligne composite ; et
des moyens pour classer ladite largeur de ligne composite dans la catégorie des largeurs de lignes composites normales ou dans la catégorie des largeurs de lignes composites anormales.

EP 0 234 524 B1

# FIG. I.

INTENSITY

← PPM

# FIG. 2.

## *FIG. 3.*

## *FIG. 5.*

# FIG. 4.